# EUROPEAN PATENT SPECIFICATION

(11) **EP 0 580 953 B1**
(45) Date of publication and mention of the grant of the patent: **12.06.1996**
(21) Application number: 93105260.9
(22) Date of filing: 30.03.1993
(51) Int. Cl.: H01L 33/00

(54) **GaP light emitting device and method for fabricating the same**
Lichtemittierende GaP-Vorrichtung und Verfahren zu ihrer Herstellung
Dispositif émetteur de lumière en GaP et sa méthode de fabrication

(30) Priority: 31.07.1992 JP 225324/92
(43) Date of publication of application: 02.02.1994
(73) Proprietor: Shin-Etsu Handotai Kabushiki Kaisha, Chiyoda-ku Tokyo 100 (JP)
(72) Inventor: Yanagisawa, Munehisa c/o Isobe Kojo Shin-Etsu, Gunma-ken (JP); Higuchi, Susumu c/o Isobe KojoShin-Etsu, Gunma-ken (JP); Tamura, Yuki c/o Isobe Kojo, Shin-Etsu, Gunma-ken (JP); Nakamura, Akio c/o Isobe Kojo, Shin-Etsu, Gunma-ken (JP); Otaki, Toshio c/o Isobe Kojo, Shin-Etsu, Gunma-ken (JP)
(74) Representative: Baronetzky, Klaus, Dipl.-Ing.

(56) References cited:
- US-A- 4 180 423
- PATENT ABSTRACTS OF JAPAN vol. 14, no. 68 (C-686)8 February 1990 & JP-A-12 090 597 (SUMITOMO ELECTRIC IND LTD)
- PATENT ABSTRACTS OF JAPAN vol. 11, no. 206 (C-433)3 July 1987 & JP-A-62 030 700 (SHIN ETSU HANDOTAI) 9 February 1987
- PATENT ABSTRACTS OF JAPAN vol. 13, no. 158 (C-586)17 April 1989 & JP-A-63 315 599 (MITSUBISHI MONSANTO CHEM CO) 23 December 1988
- PATENT ABSTRACTS OF JAPAN vol. 3, no. 152 (C-67)14 December 1979 & JP-A-54 128 990 (TOSHIBA CORP) 5 October 1979
- JOURNAL OF CRYSTAL GROWTH vol. 96, no. 3 , July 1989 , AMSTERDAM NL pages 605 - 608 J. NISHIO AND K. TERASHIMA 'Influence of melt preparation on residual impurity concentration in semi-insulating LEC GaAs'

## Description

### FIELD OF THE INVENTION

This invention relates to a semiconductor substrate for GaP type light emitting devices and a method for fabricating the same, and in particular to a semiconductor substrate for GaP type light emitting devices, in which a plurality of GaP layers are formed, used for fabricating GaP type light emitting devices which emit red light, and a method for fabricating the same.

### BACKGROUND OF THE INVENTION

Light emitting devices are fabricated generally by the steps of forming a plurality of semiconductor layers on a semiconductor substrate to fabricate a multi-layer semiconductor substrate having a pn junction and fabricating the substrates to devices. Among these light emitting devices, GaP type light emitting diodes which emit red light are fabricated from a semiconductor substrate for light emitting device, consisting of a n-type GaP single crystal substrate on which n-type and p-type GaP layers are formed, as is described in US-A-4 180 423.

The compound semiconductor GaP does not emit red light by itself even if a pn junction is formed in a substrate consisting thereof, so that zinc (Zn) and oxigen (O) are doped into a p-type layer, and pairs of Zn-O which become light emitting centers are formed in the p-type layer. GaP type light emitting diodes fabricated from the semiconductor substrate for GaP type light emitting devices emit red light having a peak wavelength of about 700 nm.

However, according to the conventional light emitting devices fabricated from the semiconductor substrate for GaP type light emitting devices processed by the above conventional method, there is a disadvantage in that substantially high luminance can not be obtained.

### SUMMARY OF THE INVENTION

Accordingly, it is an object of this invention to provide a GaP light emitting device with higher luminance than the conventional light emitting devices and a method for fabricating the same.

According to this invention, a GaP light emitting devices as set out in Claim 1 includes an n-type GaP single crystal substrate and an n-type GaP layer and a p-type GaP layer formed on the n-type GaP single crystal substrate, wherein concentration of carbon contained in the n-type GaP single crystal substrate is equal to or lower than 1.0 × 10¹⁷ atoms/cm³. A method for its fabrication is specified in Claim 5.

If the n-type GaP single crystal is grown by the Liquid Encapsulation Czochralski (LEC) method, an n-type GaP single crystal containing carbon of the concentration as stated above is obtained by growing the single crystal using boron oxide (B₂O₃), as liquid for encapsulation, containing at least 200 ppm of water, and then an n-type GaP single crystal substrate containing carbon of the concentration as stated above.

### BRIEF DESCRIPTION OF THE DRAWINGS

This invention will be explained in more detail in conjunction with appended drawings.

Fig. 1 is a schematic cross-sectional view illustrating the cross-sectional structure of the semiconductor substrate for light emitting devices in an embodiment according to the invention.

Fig. 2 is a structural view of an apparatus used for growing an n-type GaP single crystal in the embodiment according to the invention.

Fig. 3 is a graph showing the relation between the carbon concentration in the n-type GaP single crystal substrate and the luminance of the light emitting device fabricated therefrom.

Fig. 4 is a graph showing the ralation between amount of water in B₂O₃ used for growing the n-type GaP single crystal by the LEC method and the carbon concentration in the n-type GaP single crystal substrate obtained from the n-type GaP single crystal.

### DESCRIPTION OF THE PREFERRED EMBODIMENT

An embodiment of this invention will be explained by referring to the attached drawings.

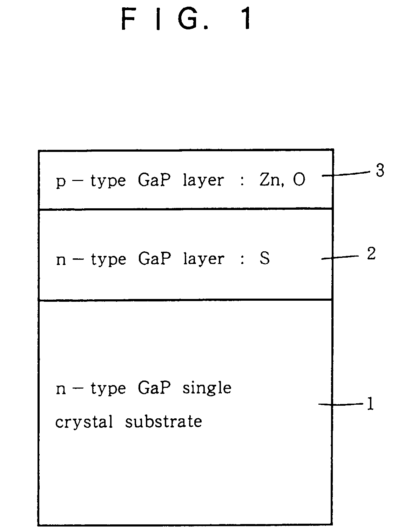

Figure 1 shows a GaP light emitting device. In the GaP light emitting device of this embodiment, an n-type GaP layer 2 and a p-type GaP layer 3 are successively formed on an n-type GaP single crystal substrate 1. Sulfur (S) and zinc (Zn) are used as dopants as n-type and p-type sources, for example. The p-type GaP layer 3 is doped with oxide (O) as well as Zn.

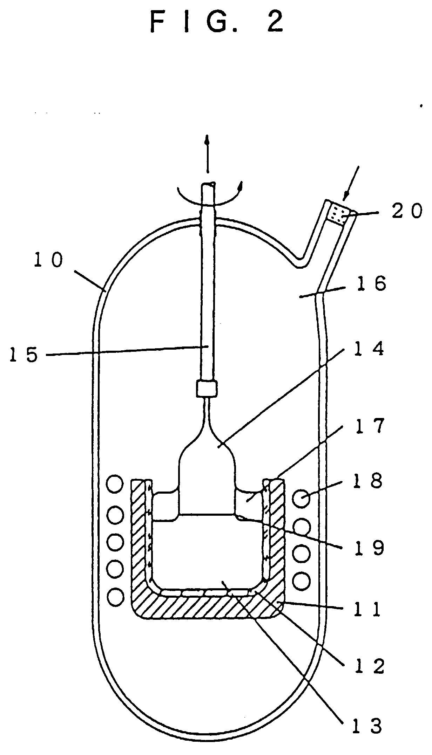

A method for fabricating the GaP light emitting device mentioned above is described below, for example. First, the n-type GaP single crystal substrate 1 is fabricated from the n-type GaP single crystal grown by the LEC method, for example. In more detail, the growth step of the GaP single crystal by the LEC method is carried out using an apparatus shown in Fig. 2. In Fig. 2, a crucible 12 supported by a susceptor 11 is provided in a pressure vessel 10, and a GaP melt 13 is included in the crucible 12.

The GaP melt 13 is covered on the top surface with B₂O₃ 17 which is lighter than the GaP melt 13 and is transparent. In order to avoid dissociation of GaP, the inside of the pressure vessel 10 is pressurized with an inert gas such as nitrogen 16. A GaP single crystal 14 is grown as being pulled out of the GaP melt 13 by a rotating rod 15. Further, the GaP melt 13 is heated by a heater 18 so that an interface 19 between the fused GaP 13 and the GaP single crystal 14 is kept at 1470°C, corresponding to the melting point of GaP. The inside of the pressure vessel 10 is monitored through a window 20, for example, by a TV monitor.

The GaP single crystal 14 grown by the process explained above is sliced to obtain GaP single crystal substrates 1, and the epitaxial layers are formed on the substrate 1 by the liquid phase epitaxy (LPE). In more detail, a solution which is prepared by solving polycrystalline GaP in a Ga melt is positioned on the substrate at 1000°C, for example. Next, the solution is cooled to make GaP in the solution precipitate and grow a GaP layer on the substrate. In the process, n-type dopants such as sulfer are added to the solution for growing the n-type GaP layer 2, and p-type dopants such as zinc or oxide are added thereto for growing the p-type GaP layer 3.

Thus, a semiconductor substrate for light emitting devices, which is a multi-layer GaP substrate, is obtained, wherein the n-type GaP layer and the p-type GaP layer are successively formed on the n-type GaP single crystal substrate. Then, n-electrodes are formed on the GaP single crystal substrate side of the semiconductor substrate for light emitting devices and p-electrodes are formed on the p-type GaP layer side thereof, respectively. Then, after being cut into single chips, each chip is mounted on a frame and wire-bonded, and encapsulated in epoxy resin, for example. Thus, light emitting diodes which emit red light are obtained.

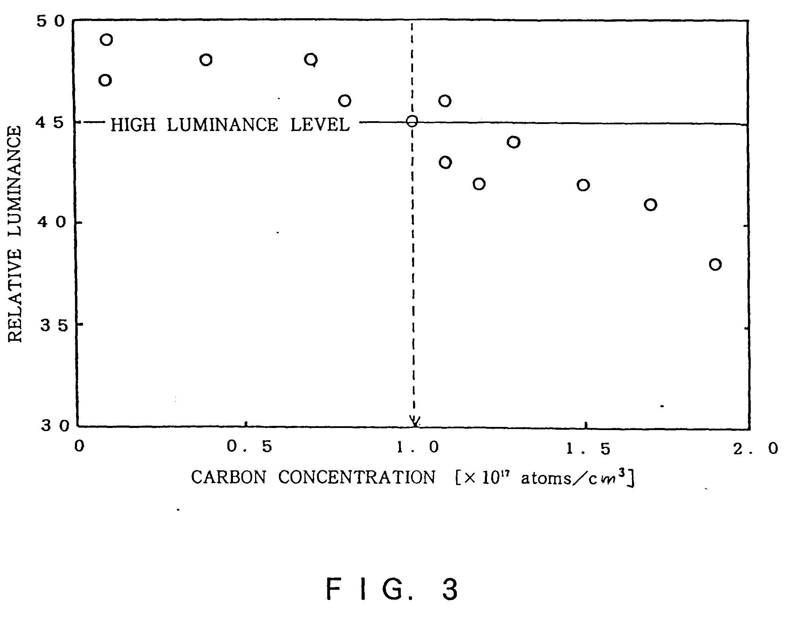

Fig. 3 shows the relation between the carbon concentration in the n-type GaP single crystal substrate and relative luminance of the light emitting devices which emit red light, fabricated from the semiconductor substrate for light emitting devices. As understood by Fig. 3, the luminance becomes higher as the carbon concentration decreases, and the carbon concentration in the n-type GaP single crystal substrate is required to be equal to or lower than 1.0 × 10¹⁷ atoms/cm³ to obtain light emitting devices having relative luminance higher than 45.

In order to obtain the n-type GaP single crystal substrate with carbon concentration equal to or lower than 1.0 × 10¹⁷ atoms/cm³, the n-type GaP single crystal grown from GaP polycrystal with originally low carbon concentration is preferably used as a starting material, for example. In this method, it is confirmed that the carbon concentraion in the GaP single crystal substrate is equal to or lower than 1.0 × 10¹⁷ atoms/cm³ when a GaP polycrystal with a carbon concentration lower than 1.0 × 10¹⁸ atoms/cm³ is used as the starting material.

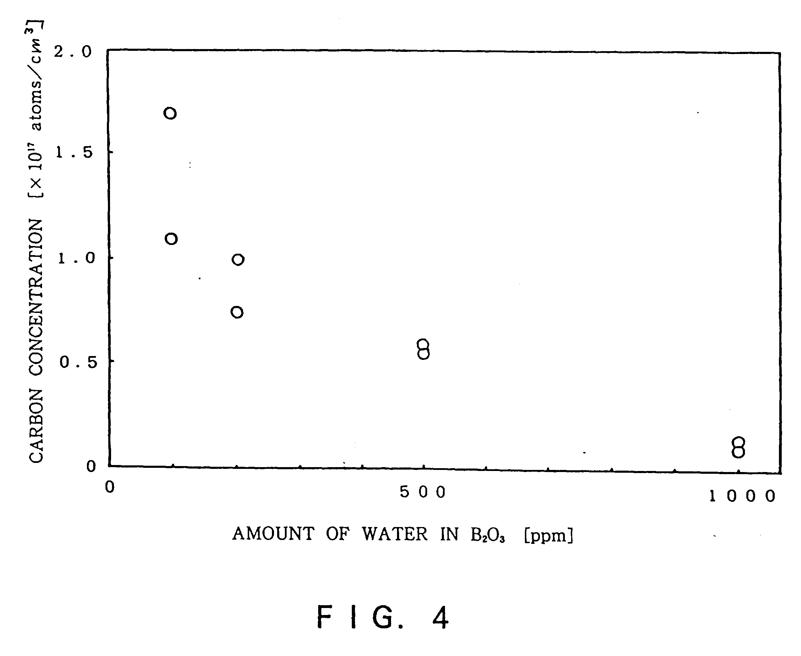

On the other hand, when the n-type GaP single crystal is grown by the LEC method, it is possible to control the carbon concentration by controlling the amount of water contained in B₂O₃ used in the growth process as the encapsulation liquid. This connection is investigated in the article of J. Nishio and K. Terashima in Journal of Crystal Growth, Vol. 96, pages 605-608 (1989). The fabrication of a GaAs single crystal with reduced variation of the carbon concentration is described in JP-A-1 290 597. Fig. 4 shows the relation between amount of water contained in B₂O₃ used in the growth process and the carbon concentration in the GaP single crystal. As understood by Fig. 4, the carbon concentration in the n-type GaP single crystal becomes low as amount of water in B₂O₃ increases. Especially, the carbon concentration decreases drastically and becomes equal to or lower than 1.0 × 10¹⁷ atoms/cm³ when the amount of water in B₂O₃ becomes larger than 200 ppm. Therefore, the carbon concentration in the n-type GaP single crystal can be kept low by controlling the amount of water in B₂O₃, contributing to the improvement of luminance of the light emitting devices. Although the amount of water in B₂O₃ is not limited as far as the amount of water is not less than 200 ppm, there may be disadvantages in scope of growing GaP single crystal if the amount of water in B₂O₃ is larger than 1000 ppm. For example, chemical reactions may occur and the B₂O₃ layer may become opaque or crystal growth may be affected adversely.

As described above, according to the invention, a GaP single crystal substrate with the carbon concentration equal to or lower than 1.0 × 10¹⁷ atoms/cm³ can be obtained, and it is possible to fabricate light emitting devices of high luminance by a semiconductor substrate for light emitting devices including the GaP single crystal substrate.

Although the invention has been described with respect to a specific embodiment for complete and clear disclosure, the appended claims are not to be thus limited.

## Claims

1. A GaP light emitting device, comprising:
an n-type GaP single crystal substrate;
an n-type GaP layer formed on said n-type GaP single crystal substrate; and
a p-type GaP layer formed on said n-type GaP layer,
characterised in that the carbon concentration in said n-type GaP single crystal substrate is not more than 1.0 × 10¹⁷ atoms/cm³.

2. A GaP light emitting device, according to Claim 1,
wherein said n-type GaP layer is doped with sulfur.

3. A GaP light emitting device, according to Claim 1,
wherein said p-type GaP layer is doped with zinc.

4. A GaP light emitting device, according to Claim 1,
wherein said p-type GaP layer is doped with oxide as well as Zn.

5. A method for fabricating a GaP light emitting device according to any one of Claims 1 to 4, comprising the steps of:
growing an n-type GaP single crystal by the Liquid Encapsulation Czochralski method and
forming an n-type GaP layer and a p-type GaP layer successively on a semiconductor substrate obtained from said n-type GaP single crystal, characterised in that B₂O₃ containing water corresponding to 200 ppm or more is used as an encapsulation liquid, so that the carbon concentration in said n-type GaP single crystal is not more than 1.0 × 10¹⁷ atoms/cm³.

## Patentansprüche

1. Licht-emittierende GaP-Vorrichtung, enthaltend:
ein GaP-Einkristallsubstrat vom n-Typ;
eine auf dem GaP-Einkristallsubstrat vom n-Typ erzeugte GaP-Schicht vom n-Typ; und
eine auf der GaP-Schicht vom n-Typ erzeugte GaP-Schicht vom p-Typ,
dadurch gekennzeichnet, daß die Kohlenstoffkonzentration in dem GaP-Einkristallsubstrat vom n-Typ nicht höher als 1,0 x 10¹⁷ Atome/cm³ liegt.

2. Licht-emittierende GaP-Vorrichtung nach Anspruch 1, worin die GaP-Schicht vom n-Typ mit Schwefel dotiert ist.

3. Licht-emittierende GaP-Vorrichtung nach Anspruch 1, worin die GaP-Schicht vom p-Typ mit Zink dotiert ist.

4. Licht-emittierende GaP-Vorrichtung nach Anspruch 1, worin die GaP-Schicht vom p-Typ mit Oxid und Zink dotiert ist.

5. Verfahren zur Herstellung einer Licht-emittierenden GaP-Vorrichtung nach einem der Ansprüche 1 bis 4, welches die [folgenden] Schritte umfaßt:
Züchtung eine GaP-Einkristalls vom n-Typ nach der Flüssigkeitseinschluß-Czochralski-Methode und
aufeinanderfolgende Erzeugung einer GaP-Schicht vom n-Typ und einer GaP-Schicht vom p-Typ auf einem Halbleitersubstrat, das aus dem GaP-Einkristall vom n-Typ erhalten wurde, dadurch gekennzeichnet, daß B₂O₃-haltiges Wasser mit 200 ppm oder mehr als Einschlußflüssigkeit verwendet wird, so daß die Kohlenstoffkonzentration in dem GaP-Einkristall nicht höher als 1,0 x 10¹⁷ Atome/cm³ liegt.

## Revendications

1. Dispositif émetteur de lumière en GaP comprenant :
un substrat en GaP monocristallin de type n ;
une couche en GaP de type n formée sur ledit substrat en GaP monocristallin de type n ; et
une couche en GaP de type p formée sur ladite couche en GaP de type n,
caractérisé en ce que la concentration du carbone dans ledit substrat en GaP monocristallin de type n ne dépasse pas 1,0 x 10¹⁷ atomes/cm³.

2. Dispositif émetteur de lumière en GaP selon la revendication 1, dans lequel ladite couche en GaP de type n est dopée au soufre.

3. Dispositif émetteur de lumière en GaP selon la revendication 1, dans lequel ladite couche en GaP de type p est dopée au zinc.

4. Dispositif émetteur de lumière en GaP selon la revendication 1, dans lequel ladite couche en GaP de type p est dopée à l'oxyde et également au zinc.

5. Procédé de fabrication d'un dispositif émetteur de lumière en GaP selon l'une quelconque des revendications 1 à 4, comprenant les opérations suivantes :
faire croître du GaP monocristallin de type n par la méthode Czochralski d'encapsulation par un liquide ; et
former successivement une couche en GaP de type n et une couche en GaP de type p sur un substrat semi-conducteur obtenu à partir du GaP monocristallin de type n, caractérisé en ce que du B₂O₃ contenant de l'eau, à raison de 200 ppm au moins est employé comme liquide d'encapsulation pour obtenir une concentration en carbone dans ledit GaP monocristallin de type n ne dépassant pas 1,0 x 10¹⁷ atomes/cm³.
